# EUROPEAN PATENT SPECIFICATION

(11) **EP 4 509 849 B1**
(45) Date of publication and mention of the grant of the patent: **09.09.2026**
(21) Application number: 23787584.4
(22) Date of filing: 07.04.2023
(51) Int. Cl.: G01R 31/385, G01R 31/387, G01R 31/367, B60L 58/12

(54) **OCV-SOC CALIBRATION METHOD AND APPARATUS, OCV-SOC ESTIMATION METHOD AND APPARATUS, AND MEDIUM AND VEHICLE**
OCV-SOC-KALIBRIERUNGSVERFAHREN UND -VORRICHTUNG, OCV-SOC-SCHÄTZUNGSVERFAHREN UND -VORRICHTUNG SOWIE MEDIUM UND FAHRZEUG
PROCÉDÉ ET APPAREIL D'ÉTALONNAGE D'OCV-SOC, PROCÉDÉ ET APPAREIL D'ESTIMATION D'OCV-SOC, ET SUPPORT ET VÉHICULE

(30) Priority: 14.04.2022 CN 202210391552
(43) Date of publication of application: 19.02.2025
(73) Proprietor: Great Wall Motor Company Limited, Baoding, Hebei 071000 (CN)
(72) Inventor: KANG, Wenrong, Baoding, Hebei 071000 (CN); HE, Jiaxin, Baoding, Hebei 071000 (CN)
(74) Representative: Klunker IP Patentanwälte PartG mbB
(86) International application number: PCT/CN2023/086791
(87) International publication number: WO 2023/197939

(56) References cited:
- EP-A1- 3 783 377
- CN-A- 108 829 911
- CN-A- 108 829 911
- CN-A- 109 856 542
- CN-A- 112 415 399
- CN-A- 115 308 616
- JP-A- 2021 071 415
- US-A1- 2021 141 028
- QIANG GUO, SUN WEI-MING: "Research on SOC estimation method of lead-acid battery based on LPV theory", CHINESE BATTERY INDUSTRY, vol. 22, no. 3, 25 June 2018 (2018-06-25), pages 115 - 119, XP093098832
- DENG-FANG BAN, ,ZHENG YAN-PING, CHANG CHENG-CHENG, SUN WEI-MING: "Study on hysteresis characteristics of lithium iron phosphate battery", CHINESE JOURNAL OF POWER SOURCES, vol. 43, no. 7, 20 July 2021 (2021-07-20), pages 1121 - 1124, XP093098839

## Description

### TECHNICAL FIELD

The present invention relates to the technical field of batteries, and in particular relates to a calibration method of an OCV-SOC functional relational expression of a battery and a corresponding apparatus, an estimation method of an SOC of a battery and a corresponding apparatus, a computer-readable storage medium, a corresponding vehicle, and a computer program product.

### BACKGROUND

In a battery management system, a state of charge (SOC) of a battery is a very important battery parameter. The SOC represents a percent value of a remaining charge of a battery pack and is used to evaluate the current remaining available capacity of the battery pack. An accurate estimation of the SOC can guarantee relevant strategies of a whole vehicle, the safety of a battery and the experience of a driver and passengers. By means of an SOC value, the remaining capacity of the battery in the current state can be known, and it is convenient for the battery management system to issue various instructions to the battery. An open circuit voltage, that is, an end voltage of the battery in an open circuit state, is expressed as OCV. It is generally believed that a polarization effect of the battery has been eliminated and the battery has reached a stable state by standing for a long time after charge or discharge, at this time, a voltage across two ends of the battery is the open circuit voltage which is not impacted by a charge or discharge current and is related to a material and the SOC of the battery. At a certain temperature, the SOC of the battery is in a one-to-one correspondence with the open circuit voltage.

An SOC-OCV curve of the battery is an important fundamental curve of a lithium battery and is mainly used to collect the open circuit voltage to estimate the SOC of the battery, that is, the remaining capacity of the battery can be known by measuring the OCV. Therefore, a basic task for formulating a battery SOC estimation strategy is to accurately acquire the SOC-OCV curve of the battery. An example of such an acquisition method and device is disclosed in EP 3 783 377 A1.

However, due to a hysteresis characteristic of the battery, before the battery is standing or in an OCV test, whether the battery is in a state of charge or a state of discharge will affect an OCV value of the battery. Moreover, after the battery is fully charged, the OCV of the battery cannot be completely decreased to a discharge OCV even it is standing for a long time, which leads to an inaccuracy of a discharge SOC-OCV curve, thereby resulting in an estimation error of an SOC of a lithium-ion battery.

### SUMMARY

To this end, it is an object of the present invention is to provide a calibration method of an OCV-SOC functional relational expression of a battery and a corresponding apparatus, an estimation method of an SOC of a battery and a corresponding apparatus, a computer-readable storage medium, a vehicle, and a computer program product, so as to solve the problem that a discharging OCV-SOC curve of a battery is inaccurate due to a hysteresis characteristic of the battery.

The object is achieved regarding the calibration method of an OCV-SOC functional relational expression of a battery with the features of independent claim 1, regarding the estimation method of the SOC of a battery with the features of independent claim 9, regarding the calibration apparatus of an OCV-SOC curve of a battery with the features of independent claim 10, regarding the estimation apparatus of the SOC of a battery with the features of independent claim 11, regarding the computer-readable storage medium with the features of independent claim 12, regarding the vehicle with the features of independent claim 13, and regarding the computer program product with the features of independent claim 14. Further, embodiments are defined in the dependent claims 2-8.

Compared with the prior art, the calibration method of an OCV-SOC functional relational expression of a battery provided by the present invention has the following advantages.

In the calibration method provided by the present invention, the impact of hysteresis effects brought by the state of charge and the state of discharge of the battery is taken into consideration, the charging and discharging OCV-SOC curve, the charging OCV-SOC curve and the discharging OCV-SOC curve are fitted, and functional relationships between hysteresis parameters and an SOC are established, such that an OCV-SOC functional relational expression is obtained. By using the method, the problem that the OCV is obviously decreased due to a hysteresis characteristic after the battery is fully charged is avoided, the impact brought by the hysteresis characteristic of the battery is decreased, and the obtained OCV-SOC functional relational expression can be used to calculate the corresponding SOC value after the OCV of the battery is measured. Moreover, compared with the prior art in which the SOC is only calculated by using the discharging OCV-SOC curve, the present invention achieves a more accurate result.

Compared with the prior art, the estimation method of an SOC of a battery has the same advantages as the above-mentioned calibration method of an OCV-SOC functional relational expression of a battery, so as to be no longer repeated herein.

Compared with the prior art, the calibration apparatus of an OCV-SOC functional relational expression of a battery has the same advantages as the above-mentioned calibration method of an OCV-SOC functional relational expression of a battery, so as to be no longer repeated herein.

Compared with the prior art, the computer-readable storage medium has the same advantages as the above-mentioned calibration method of an OCV-SOC functional relational expression of a battery, so as to be no longer repeated herein.

Compared with the prior art, the electronic device has the same advantages as the above-mentioned calibration method of an OCV-SOC functional relational expression of a battery, so as to be no longer repeated herein.

### BRIEF DESCRIPTION OF THE DRAWINGS

In order to describe the technical solutions of the present invention more clearly, the accompanying drawings required for describing the present invention will be briefly introduced below. Apparently, the accompanying drawings in the following description show only some embodiments of the present invention.
FIG. 1 is a step process diagram of a calibration method of an OCV-SOC functional relational expression of a battery;
FIG. 2 is a step process diagram of a battery charging and discharging OCV-SOC curve calibration method;
FIG. 3 is a schematic diagram of a charging and discharging OCV-SOC curve, a charging OCV-SOC curve and a discharging OCV-SOC curve of a battery;
FIG. 4 schematically shows a block diagram of an electronic device for performing the method; and
FIG. 5 schematically shows a storage unit for holding or carrying program codes for implementing the method.

Description for reference symbols in the accompanying drawings: A-charging and discharging OCV-SOC curve, B-charging OCV-SOC curve, and C-discharging OCV-SOC curve.

### DETAILED DESCRIPTION

Hereinafter, exemplary embodiments of the present invention will be described in more detail in conjunction with the accompanying drawings. Although exemplary embodiments of the present invention are shown in the accompanying drawing, it should be understood that the present invention can be embodied in various forms, and is not limited by the embodiments set forth herein, rather defined by the claims only. The embodiments are provided for understanding the present invention more thoroughly and integrally.

In order to facilitate understanding the technical solutions of the present invention, the related art involved is described firstly.

At present, there have been four main types of SOC estimation methods: an ampere-hour integral method, a Kalman filter method, an artificial neural network method and an open circuit voltage method. The main principle of the ampere-hour integral method is that an external structure and chemical reaction of a battery are not taken into consideration, a current flowing through the battery is only continuously recorded and detected for a long time and is subjected to integral calculation to obtain a remaining capacity, the accuracy of the ampere-hour integral method is closely related to an initial capacity of the battery and the accuracy of current detection, when it is detected that a discharge current is unstable or even fluctuates violently, greater measurement errors are caused, at the same time, with the increase of discharge time, accumulated errors are generated and increased, there will be greater errors in the initial capacity in the later period, and finally, there will be a serious deviation between an estimated value of an SOC and an actual value. The Kalman filter method is an optimized autoregressive data processing algorithm and is a data processing technology proposed by Kalman and used to restore real data. A basic principle of the Kalman filter method is that a battery is regarded as a power system, an SOC is used as a quantity of an internal state, and continuous prediction and update are performed during the continuous operation of the algorithm to implement the optimal estimation in the sense of minimum variance. However, there is a great deal of data operation during the operation process of a Kalman filter algorithm, and therefore, the method requires a high calculation capacity of a processor. In a process of model parameter identification, the parameter drift brings a huge amount of computation, and therefore, the method is rarely used in a single chip microcomputer. For the artificial neural network method, when it is used to estimate an SOC of a battery, a voltage and a current of the battery are usually used as input layer samples, a corresponding SOC value can be obtained by inputting any data only after an appropriate training algorithm and a sufficient quantity of training samples are selected; and although the artificial neural network method has higher precision, it is more dependent on training data and a training method; and due to the large quantity of training samples, a large quantity of work will be brought, and higher hardware requirements are needed. The open circuit voltage method refers to that a capacity of a battery is firstly kept constant at a specific current and a specific temperature to be measured, an SOC of the battery is adjusted at a certain capacity interval based on a constant capacity, an open circuit voltage of the battery is measured once after the battery is stood sufficiently until the battery reaches a power off state, each of points is in a one-to-one correspondence, and thus, an SOC-OCV curve of the battery at the temperature is formed. However, a hysteresis effect brought by a polarization process of the battery will lead to inaccuracy of the measured OCV, which is also the reason why the obtained SOC-OCV curve is not accurate enough.

In a process of charging and discharging cycle of a lithium ion battery, there is a phenomenon that OCVs are converged to different values while SOCs are the same, which is called hysteresis by researchers. Due to the existence of a hysteresis effect, OCV-SOC functional relationships of the battery are not in one-to-one correspondence, and different corresponding open circuit voltage values can be obtained on the same SOC point according to differences among factors such as currents, ambient temperatures and charging and discharging histories. The hysteresis effect of the battery is mainly embodied in that it depends on whether the battery is in a state of charge or a state of discharge previously. The OCV value in a charging process is usually greater than the OCV value in a discharging process in the same SOC state.

On the basis of the above description, the technical solutions of the present invention will be introduced as follows.

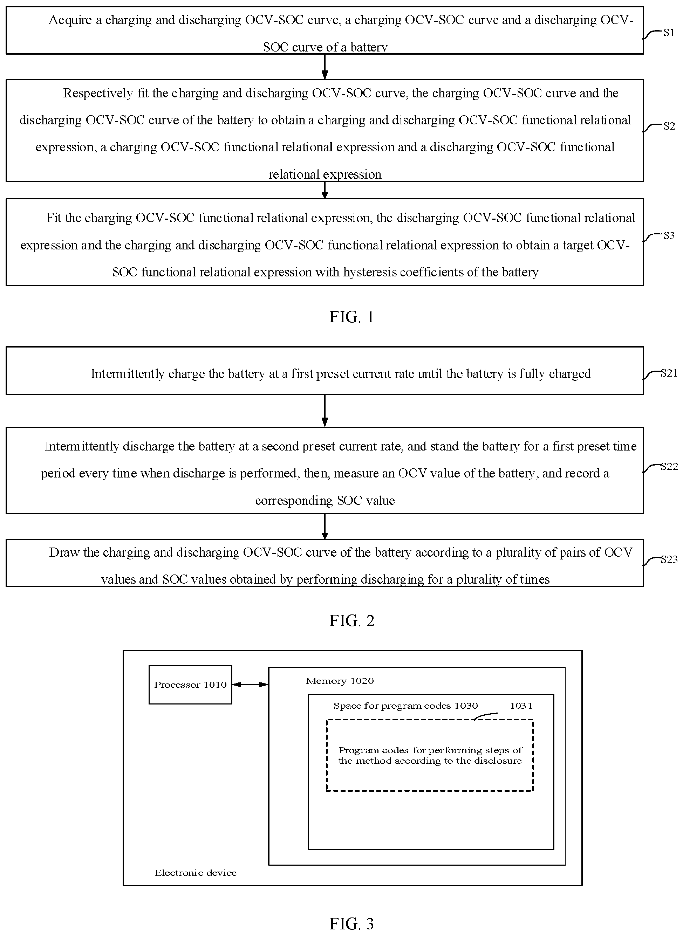

A calibration method of an OCV-SOC functional relational expression of a battery. FIG. 1 is a step process diagram of the method. As shown in FIG. 1, the method includes:
a charging and discharging OCV-SOC curve, a charging OCV-SOC curve and a discharging OCV-SOC curve of a battery are acquired;
the charging and discharging OCV-SOC curve, the charging OCV-SOC curve and the discharging OCV-SOC curve of the battery are respectively fitted to obtain a charging and discharging OCV-SOC functional relational expression, a charging OCV-SOC functional relational expression and a discharging OCV-SOC functional relational expression; and
the charging OCV-SOC functional relational expression, the discharging OCV-SOC functional relational expression and the charging and discharging OCV-SOC functional relational expression are fitted to obtain a target OCV-SOC functional relational expression with hysteresis coefficients of the battery.

The charging and discharging OCV-SOC curve refers to a charging and discharging SOC-OCV curve formed by fully charging the battery with a small-rate current intermittently, slowly and stably, then, completing one-time discharge at every certain SOC interval, standing the battery in this state for a period of time, recording an OCV of the stood battery, and then performing one-to-one correspondence on each point. The charging OCV-SOC curve refers to a charging OCV-SOC curve obtained by charging the battery with a small-rate current until a specific SOC value is reached, and measuring to obtain a corresponding OCV value of the battery after standing the battery for a period of time. The discharging OCV-SOC curve refers to a discharging OCV-SOC curve mainly formed by fully charging the battery with a constant current, then, standing the battery for a period of time until the battery is stable, then, completing one-time discharge at every certain SOC interval, standing the battery in this state for a period of time, recording an OCV of the stood battery, and then performing one-to-one correspondence on each point.

The battery has a hysteresis effect, that is, the OCV of the battery is not only related to the SOC, but also related to whether the battery is in a state of charge or a state of discharge before the battery is stood, such that the three curves are different from each other. The above-mentioned three curves are converted into the three functional relational expressions (respectively with a charge hysteresis coefficient, a discharge hysteresis coefficient and a charging and discharging hysteresis coefficient) and are then fitted, such that an OCV and SOC functional relational expression with the hysteresis coefficients is obtained, functional relationships between hysteresis parameters and an OCV and an SOC are established, thereby, reducing the impact brought by the hysteresis characteristic of the battery when an SOC value is measured.

Optionally, the charging and discharging OCV-SOC functional relational expression is:
${U}_{charge and discharge} = {P}_{6} ∗ {X}^{6} + {P}_{5} ∗ {X}^{5} + {P}_{4} ∗ {X}^{4} + {P}_{3} ∗ {X}^{3} + {P}_{2} ∗ {X}^{2} + {P}_{1} ∗ {X}^{1} + {P}_{0}$
wherein *U_{charge and discharge}* is an OCV value, X is an SOC value, and P is a coefficient;
the charging OCV-SOC functional relational expression is expressed as:
   ${U}_{charge} = P {′}_{6} ∗ {X}^{6} + P {′}_{5} ∗ {X}^{5} + P {′}_{4} ∗ {X}^{4} + P {′}_{3} ∗ {X}^{3} + P {′}_{2} ∗ {X}^{2} + P {′}_{1} ∗ {X}^{1} + P {′}_{0}$
wherein *U_{charge}* is an OCV value, X is an SOC value, and P' is a coefficient; and
the discharging OCV-SOC functional relational expression is expressed as:
   ${U}_{discharge} = P {"}_{6} ∗ {X}^{6} + P {"}_{5} ∗ {X}^{5} + P {"}_{4} ∗ {X}^{4} + P {"}_{3} ∗ {X}^{3} + P {"}_{2} ∗ {X}^{2} + P {"}_{1} ∗ {X}^{1} + P {"}_{0}$
wherein *U_{discharge}* is an OCV value, X is an SOC value, and P" is a coefficient.

Optionally, the target OCV-SOC functional relational expression is expressed as:

$\begin{matrix}U = \left({X}^{6}+{X}^{5}+{X}^{4}+{X}^{3}+{X}^{2}+{X}^{1}+{X}^{0}\right) \\ ∗ \left(\frac{{P}_{6}}{\frac{1}{P {′}_{6}} + \frac{1}{P {"}_{6}}}∗\frac{{P}_{5}}{\frac{1}{P {′}_{5}} + \frac{1}{P {"}_{5}}}∗\frac{{P}_{4}}{\frac{1}{P {′}_{4}} + \frac{1}{P {"}_{4}}}∗\frac{{P}_{3}}{\frac{1}{P {′}_{3}} + \frac{1}{P {"}_{3}}}∗\frac{{P}_{2}}{\frac{1}{P {′}_{2}} + \frac{1}{P {"}_{2}}}∗\frac{{P}_{1}}{\frac{1}{P {′}_{1}} + \frac{1}{P {"}_{1}}}\right)\end{matrix}$
wherein U is an OCV value, X is an SOC value, P is a coefficient in a charging and discharging OCV-SOC function, P' is a coefficient in a charging OCV-SOC function, and P" is a coefficient in a discharging OCV-SOC function.

The obtained OCV-SOC curves are respectively fitted to obtain the charging and discharging OCV-SOC functional relational expression, the charging OCV-SOC functional relational expression and the discharging OCV-SOC functional relational expression; each of the functional relational expressions includes the corresponding hysteresis coefficients P, P' and P", and then the above-mentioned three functional relational expressions are fitted to form the OCV-SOC functional relational expression with the hysteresis coefficients P, P' and P", and thus, the obtained OCV-SOC functional relational expression, compared with an existing charging OCV-SOC curve or discharging OCV-SOC curve, takes the impact of the hysteresis effect on the OCV of the battery into sufficient consideration and introduces the hysteresis coefficients to the functional relational expression, such that an SOC value obtained by measuring a voltage is more accurate.

Optionally, FIG. 2 is a schematic diagram of a calibration process for a charging and discharging OCV-SOC curve. As shown in FIG. 2, the step that a charging and discharging OCV-SOC curve of a battery is acquired includes:
the battery is intermittently charged at a first preset current rate until the battery is fully charged;
the battery is intermittently discharged at a second preset current rate, after the battery is stood for a first preset time period every time when discharge is performed, then, an OCV value of the battery is measured, and a corresponding SOC value is recorded; and
the charging and discharging OCV-SOC curve of the battery is drawn according to a plurality of pairs of OCV values and SOC values obtained by performing discharge for a plurality of times.

The current rate refers to a current value output by the battery for releasing a rated capacity thereof within a specified time and can be used to represent a rate of charge. It should be known that the hysteresis effect of the battery is also impacted by the current rate in the charging process. Specifically, when the battery is charged with a constant current at a relatively large current rate, the battery can be fully charged quickly, however, the hysteresis effect generated thereby is stronger, the OCV of the battery will be slowly declined within a period of time after the battery is fully charged, and the OCV of the battery cannot be stabilized even if the battery is stood for a long time. If the battery is intermittently charged at a relatively small current rate, that is, one-time charge is completed at a certain SOC interval, then, the battery is charged once again after standing for a period of time until the battery is fully charged, In this way, the battery is fully charged slowly and stably, and the generated hysteresis effect is weak, thereby the OCV value of the fully-charged battery is stable enough to avoid a significant decrease.

When the battery is in a steady state and is not impacted by the hysteresis effect, the OCV values and the SOC values of the battery are in one-to-one correspondence. Specifically, the OCV of the battery can be decreased with the decrease of the SOC. Therefore, the battery is intermittently discharged, a certain quantity of SOC is decreased every time, then, the battery is stood to be stable, the OCV value of the battery is measured, in this way, the plurality of pairs of OCV and SOC values are obtained, and thus, the charging and discharging OCV-SOC curve can be drawn. Therefore, by controlling the first preset current rate during charging, the battery is intermittently charged, in this way the battery is fully charged slowly and stably, such that the hysteresis effect of the battery can be weakened, that is, after the battery is fully charged, the OCV of the battery is stable enough to avoid the significant decrease. Moreover, by slowing the charging process of the battery, a battery temperature rise effect caused by charge can be effectively lowered, and an impact of temperature change of the battery on the measurement of the SOC and the OCV of the battery is avoided.

Optionally, the step that the battery is intermittently charged includes:
the battery is stood for a second preset time period every time when the battery is charged, and then the battery is charged for the next time, wherein a duration of the second preset time period is a duration required to wait for an OCV of the battery to be no longer decreased after the battery is charged every time.

The battery is stood for the second preset time period every time when the battery is charged, such that the hysteresis effect caused by charging this time can be eliminated, and the OCV is more stable after standing the battery is completed. Therefore, when a duration of the second preset time period of the battery is set, it is mainly considered whether the OCV of the battery can be stabilized.

Optionally, the duration of the second preset time period ranges from one to three hours. As described above, if a second preset duration is too short, the hysteresis effect of the battery will be still stronger, and by accumulation of charge for multiple times, the OCV will be decreased after the battery is fully charged, and finally, the obtained charging and discharging OCV-SOC curve is not accurate enough; and if the second preset duration is too long, it will lead to the charging process is too long, and a calibration effect of the curve is decreased.

The step that the battery is intermittently charged includes: an equivalent SOC of the battery is increased every time when charge is performed. Exemplarily, every time when charge is performed, the increased SOC of the battery is 1%, 2% or 5%, which is not limited herein.

Optionally, the first preset current rate is a current rate required when the temperature of the battery is within an allowable temperature change range during charging every time.

The battery will generate heat energy in the charging process, which will cause the temperature rise of the battery. However, the temperature of the battery will also affect the charging and discharging efficiencies, OCV and SOC of the battery, etc. Therefore, a size of the first preset current rate during charging can be controlled to avoid the significant temperature rise during charging due to a too high current rate, which will increase the number of variables and affect the accuracy of a subsequent curve calibration result. Specifically, the temperature change can be limited not to exceed 0.5°C, 0.1°C, which is not limited herein.

Optionally, the first preset current rate ranges from 1/3C to 1C.

For the first preset current rate in the charging process, the problem of a charging efficiency needs to be taken into consideration, if the current rate is too low, the charging process will be slow, and the charge efficiency is low; and the hysteresis effect and heat issues generated during charging also need to be taken into consideration, if the current rate is too high, it will lead to the strong hysteresis effect and the temperature rise of the battery.

Optionally, the step that the battery is intermittently discharged at a second preset current rate includes:
after discharge is performed every time, a pair of OCV value and SOC value obtained by discharge performed this time is compared with the discharging OCV-SOC curve of the battery;
discharging the battery is stopped in the case that the pair of OCV value and SOC value obtained by discharge performed this time coincides with the discharging OCV-SOC curve of the battery; and
the battery is intermittently discharged for the next time at the second preset current rate in the case that the pair of OCV value and SOC value obtained by discharge performed this time does not coincide with the discharging OCV-SOC curve of the battery.

The discharging OCV-SOC curve refers to that the battery is fully charged with a constant current at one time firstly according to an open circuit voltage method, and then is sufficiently stood (there is a phenomenon that the OCV is decreased), then, the battery is intermittently discharged, that is, the battery is decreased by an equivalent SOC every time, next, the battery is stood, and then the OCV value of the battery is measured and the SOC value is recorded until the battery reaches an air power state, all points of the OCV values and the OCV values are in one-to-one correspondence, and thus, an SOC-OCV curve of the battery at the temperature is formed. However, the hysteresis effect caused when the battery is fully charged will lead to inaccuracy of the measured OCV when the SOC is relatively high, which is also the reason why the obtained SOC-OCV curve is inaccurate.

FIG. 3 is a schematic diagram of a charging and discharging OCV-SOC curve, a charging OCV-SOC curve and a discharging OCV-SOC curve of the present invention. As shown in FIG. 3, a horizontal coordinate represents the SOC, a vertical coordinate represents the OCV, a curve A is the charging and discharging OCV-SOC curve of the battery, a curve B is the charging OCV-SOC curve of the battery, and a curve C is the discharging OCV-SOC curve of the battery. Wherein, the curve A, the charging and discharging OCV-SOC curve in FIG. 3 is obtained under the following experimental conditions: 1) intermittently, slowly and stably charging with a low-rate current is performed from an SOC that is equal to 0% to an SOC that is equal to 50%, one-time charging is completed at an interval of 10% of the SOC, and standing is performed at this state for three hours; 2) the battery is discharged with a constant current of 2A, one-time discharging is completed at an interval of 10% of the SOC, standing is performed at this state for three hours, and the OCV of the stood battery is recorded; and 3) step 2) is repeated until the SOC of the battery is equal to 10%. The curve C, the discharging OCV-SOC curve in FIG. 3 is obtained under the following experimental conditions: 1) intermittently, slowly and stably charging with a low-rate current is performed from an SOC that is equal to 0% to an SOC that is equal to 50%; 2) the battery is discharged with a constant current of 2A, one-time discharging is completed at an interval of 10% of the SOC, standing is performed at this state for three hours, and the OCV of the stood battery is recorded; and 3) step 2) is repeated until the SOC of the battery is equal to 10%. The curve B, the charging OCV-SOC curve in FIG. 3 is obtained under the following experimental conditions: 1) slowly and stably charging with a low-rate current is performed from an SOC that is equal to 0% to an SOC that is equal to 50%, one-time charging is completed at an interval of 10% of the SOC, standing is performed at this state for three hours, and the OCV of the stood battery is recorded; and 2) step 1) is repeated until the SOC of the battery is equal to 50%.

After the battery is fully charged, the OCV is significantly decreased due to impact from the hysteresis effect of the battery can be avoided according to the calibration method of an OCV-SOC functional relational expression of a battery, and therefore, the OCV of an OCV-SOC curve during full charge will be higher than the OCV of the discharging OCV-SOC curve. In an intermittent discharging process, with the decrease of the SOC, the impact brought by the hysteresis effect during full charge is weakened, a difference between the two curves become small, and finally, the two curves coincide. Therefore, in the case that the discharging OCV-SOC curve of the battery has been known, when it is detected that a pair of OCV value and SOC value obtained after discharging and standing at a certain time coincides with the discharging OCV-SOC curve, it means that errors caused by the hysteresis effect become small, and the subsequent OCV values and SOC values can both fall on the discharging OCV-SOC curve. Therefore, the subsequent discharging and measuring operations can be stopped, and the data of the corresponding discharging OCV-SOC curve can be directly referenced, which decreases unnecessary processes and improve efficiency.

The step that the battery is intermittently discharged includes: an equivalent SOC of the battery is decreased every time when discharge is performed. Exemplarily, every time when discharge is performed, the decreased OSC of the battery is 1% of the OSC, 2% of the OSC or 5% of the OSC, which is not limited herein.

Optionally, the step that the charging and discharging OCV-SOC curve of the battery is drawn according to a plurality of pairs of OCV values and SOC values obtained by performing discharging for a plurality of times includes:
the charging and discharging OCV-SOC curve of the battery is drawn according to the plurality of pairs of OCV values and SOC values obtained by performing discharging for a plurality of times and the discharging OCV-SOC curve of the battery.

As described above, exemplarily, when the SOC of the battery is 40% and the OCV is 3.2V(volt), and the point of the OCV is also on the discharging OCV-SOC curve of the battery, the subsequent discharging and measuring operations are stopped. Then, a partial curve on which the SOC is 40% to 100% is drawn according to the plurality of pairs of OCV values and SOC values obtained by performing discharging for a plurality of times, and the curve is combined with a curve with parts on which the SOC of the discharging OCV-SOC curve is 0% to 40% to obtain the charging and discharging OCV-SOC curve of the battery. In the case that the discharging OCV-SOC curve of the battery has been known, the charging and discharging OCV-SOC curve partially coincides with the discharging OCV-SOC curve, thereby the operation of measuring data of coinciding parts can be omitted, unnecessary processes can be decreased, and the calibration efficiencies of the curves are improved.

Optionally, the step that the battery is intermittently discharged at a second preset current rate includes:
the battery is intermittently discharged at the second preset current rate until the SOC value of the battery is decreased to 0%.

If the discharging OCV-SOC curve of the battery is not detected, the battery is intermittently discharged until the SOC value of the battery is decreased to 0%. In this way, a complete charging and discharging OCV-SOC curve with an SOC being within a range of 0% to 100% can be obtained.

The charging and discharging OCV-SOC curve, the charging OCV-SOC curve and the discharging OCV-SOC curve of the battery are acquired; the above-mentioned curves are respectively fitted to obtain the charging and discharging OCV-SOC functional relational expression, the charging OCV-SOC functional relational expression and the discharging OCV-SOC functional relational expression; and then the above-mentioned OCV-SOC functional relational expressions are fitted to obtain the target OCV-SOC functional relational expression with hysteresis coefficients of the battery. In the calibration method provided by the present invention, the impact of hysteresis effects brought by the state of charge and the state of discharge of the battery is taken into consideration, the charging and discharging OCV-SOC curve, the charging OCV-SOC curve and the discharging OCV-SOC curve are fitted, and functional relationships between hysteresis parameters and an OCV and an SOC are established, such that an OCV-SOC functional relational expression is obtained. By using the method, the impact brought by the hysteresis characteristic of the battery is decreased, and thus the drawn OCV-SOC curve is more accurate.

Based on the same inventive concept, the present invention further provides an estimation method of an SOC of a battery, including:
an OCV value of a battery is detected; and
an OCV-SOC functional relational expression of the battery obtained on the basis of the above-mentioned calibration method of an OCV-SOC functional relational expression of a battery is queried according to the OCV value to obtain a target SOC value.

Based on the same inventive concept, the present invention further provides a calibration apparatus of an OCV-SOC functional relational expression of a battery, including:
a curve measurement module configured to acquire a charging and discharging OCV-SOC curve, a charging OCV-SOC curve and a discharging OCV-SOC curve of a battery;
a calculation module configured to respectively fit the charging and discharging OCV-SOC curve, the charging OCV-SOC curve and the discharging OCV-SOC curve of the battery to obtain a charging and discharging OCV-SOC functional relational expression, a charging OCV-SOC functional relational expression and a discharging OCV-SOC functional relational expression; and
a fitting module configured to fit the charging OCV-SOC functional relational expression, the discharging OCV-SOC functional relational expression and the charging and discharging OCV-SOC functional relational expression to obtain a target OCV-SOC functional relational expression with hysteresis coefficients of the battery.

Based on the same inventive concept, the present invention further provides an estimation apparatus of an SOC of a battery, including:
a detection module configured to detect an OCV value of a battery; and
a querying module configured to query, according to the OCV value, an OCV-SOC functional relational expression of the battery obtained on the basis of the above-mentioned calibration method of an OCV-SOC functional relational expression of a battery to obtain a target SOC value.

Based on the same inventive concept, the present invention further provides a computer-readable storage medium having computer program instructions stored thereon, wherein the program instructions are executed by a processor, such that the steps of the above-mentioned OCV-SOC functional relational expression calibration method or the above-mentioned battery SOC estimation method are implemented.

Based on the same inventive concept, the present invention further provides an electronic device, including a memory and a processor, wherein the memory is configured to store information including program instructions, and the processor is configured to control the execution of the program instructions; and when the program instructions are loaded and executed by the processor, the above-mentioned calibration method of an OCV-SOC functional relational expression of a battery or the above-mentioned battery SOC estimation method is implemented.

The calibration method of an OCV-SOC functional relational expression of a battery provided by the present invention is exemplarily described herein with a specific experimental embodiment.

Step 1, the battery is intermittently charged with a current of 1/3C, and the battery is stood for one hour every time when the SOC of the battery is increased by 5%. After fully charged, the battery is stood for one hour and is intermittently discharged according to the SOC of 1%, the battery is stood for one hour after discharged every time, and a corresponding OCV value is measured until the SOC value is decreased to zero. A charging and discharging OCV-SOC curve of the battery is drawn according to a plurality of groups of recorded OCV and SOC data.

Step 2, the battery is charged with a current of 1/3C, such that the battery is stood for one hour every time when the SOC of the battery is increased by 1%, and then a corresponding OCV value is measured until the SOC is increased to 100%. A charging OCV-SOC curve of the battery is drawn according to a plurality of groups of recorded OCV and SOC data.

Step 3, the battery is charged with a constant current of 1/3C, the battery is stood for one hour after fully charged, is intermittently discharged according to the SOC of 1%, and is stood for one hour after discharged every time, and a corresponding OCV value is measured until the SOC value is decreased to zero. A discharging OCV-SOC curve of the battery is drawn according to a plurality of groups of recorded OCV and SOC data.

Step 4, the obtained three OCV-SOC curves are respectively fitted to obtain a charging and discharging OCV-SOC functional relational expression, a charging OCV-SOC functional relational expression and a discharging OCV-SOC functional relational expression.

Specifically, the charging and discharging OCV-SOC functional relational expression is:
${U}_{charge and discharge} = {P}_{6} ∗ {X}^{6} + {P}_{5} ∗ {X}^{5} + {P}_{4} ∗ {X}^{4} + {P}_{3} ∗ {X}^{3} + {P}_{2} ∗ {X}^{2} + {P}_{1} ∗ {X}^{1} + {P}_{0}$
wherein *U_{charge and discharge}* is an OCV value, X is an SOC value, P is a coefficient,
P6=-4.6518*10⁻¹¹ P5=1.6891*10⁻⁸ P4=-2.3685*10⁻⁶ P3=0.000161664. P2=-0.005556. P1=0.090494295 P0=2.7319507;
the charging OCV-SOC functional relational expression is:
   ${U}_{charge} = P {′}_{6} ∗ {X}^{6} + P {′}_{5} ∗ {X}^{5} + P {′}_{4} ∗ {X}^{4} + P {′}_{3} ∗ {X}^{3} + P {′}_{2} ∗ {X}^{2} + P {′}_{1} ∗ {X}^{1} + P {′}_{0}$
wherein *U_{charge}* is an OCV value, X is an SOC value, P' is a coefficient,
P'6=-3.9232012*10⁻¹¹ P'5=1.493615878*10⁻⁸ P'4=-2.17576541*10⁻⁶ P'3=0.000153255 P'2=-0.0054010751 P'1=0.089239190 P'0=2.7334217;
the discharging OCV-SOC functional relational expression is :
   ${U}_{discharge} = P {"}_{6} ∗ {X}^{6} + P {"}_{5} ∗ {X}^{5} + P {"}_{4} ∗ {X}^{4} + P {"}_{3} ∗ {X}^{3} + P {"}_{2} ∗ {X}^{2} + P {"}_{1} ∗ {X}^{1} + P {"}_{0}$
wherein *U_{discharge}* is an OCV value, X is an SOC value, P" is a coefficient,
P"6= -5.7773457*10⁻¹¹ P"5=2.07702*10⁻⁸ P"4=-2.89299178*10⁻⁶ P"3= 0.000196675 P"2=-0.0067352639 P"1=0.1080163 P"0=2.6694041.

Step 5, the above-mentioned OCV-SOC functional relational expressions are fitted to obtain a target OCV-SOC functional relational expression with hysteresis coefficients of the battery:

$\begin{matrix}U = \left({X}^{6}+{X}^{5}+{X}^{4}+{X}^{3}+{X}^{2}+{X}^{1}+{X}^{0}\right) \\ ∗ \left(\frac{{P}_{6}}{\frac{1}{P {′}_{6}} + \frac{1}{P {"}_{6}}}∗\frac{{P}_{5}}{\frac{1}{P {′}_{5}} + \frac{1}{P {"}_{5}}}∗\frac{{P}_{4}}{\frac{1}{P {′}_{4}} + \frac{1}{P {"}_{4}}}∗\frac{{P}_{3}}{\frac{1}{P {′}_{3}} + \frac{1}{P {"}_{3}}}∗\frac{{P}_{2}}{\frac{1}{P {′}_{2}} + \frac{1}{P {"}_{2}}}∗\frac{{P}_{1}}{\frac{1}{P {′}_{1}} + \frac{1}{P {"}_{1}}}\right)\end{matrix}$
wherein U is an OCV value, X is an SOC value, P is a coefficient in a charging and discharging OCV-SOC function, P' is a coefficient in a charging OCV-SOC function, and P" is a coefficient in a discharging OCV-SOC function.

When the SOC value of the battery is calculated, the OCV value of the battery is measured and is substituted into U in the target OCV-SOC functional relational expression, and thus, a value of X, that is, a corresponding SOC value of the battery, is obtained.

The present invention provides a calibration method of an OCV-SOC functional relational expression of a battery and apparatus, an estimation method of an SOC of a battery and apparatus, a medium and a vehicle. A charging and discharging OCV-SOC curve, a charging OCV-SOC curve and a discharging OCV-SOC curve of a battery are acquired; the above-mentioned curves are respectively fitted to obtain a charging and discharging OCV-SOC functional relational expression, a charging OCV-SOC functional relational expression and a discharging OCV-SOC functional relational expression; and then the above-mentioned OCV-SOC functional relational expressions are fitted to obtain a target OCV-SOC functional relational expression with hysteresis coefficients of the battery. In the present invention, the obtained OCV-SOC curves are respectively fitted to obtain the charging and discharging OCV-SOC functional relational expression, the charging OCV-SOC functional relational expression and the discharging OCV-SOC functional relational expression; each of the functional relational expressions includes the corresponding hysteresis coefficients P, P' and P". Then, the above-mentioned three functional relational expressions are fitted to form the OCV-SOC functional relational expression including the hysteresis coefficients P, P' and P", and thus, the obtained OCV-SOC functional relational expression, compared with an existing charging OCV-SOC curve or discharging OCV-SOC curve, takes the impact of the hysteresis effect on the OCV of the battery into sufficient consideration and introduces the hysteresis coefficients to the functional relational expression, such that an SOC value obtained by measuring a voltage is more accurate.

The apparatus described as above is only illustrative, wherein the units described as separated components can be or not be physically separated, and components displayed as units can be or not be physical units, that is, they can be located on the same place or distributed on a plurality of network units. Parts or all of the modules can be selected according to an actual demand to achieve the purpose of the solution of the present invention.

Each component of the present invention can be implemented by hardware or a software module running on one or more processors or a combination thereof. It should be understood by those skilled in the art that some or parts of functions of some or all components in the electronic device of the present invention can be implemented in practice by using a microprocessor or a digital signal processor (DSP). The present invention can also be implemented as a part or all of device or apparatus programs (such as a computer program and a computer program product) for performing the method described herein. Such a program for implementing the present invention can be stored in a computer-readable medium or can have one or more signal forms. Such a signal can be downloaded from an Internet website or provided on a carrier signal or any other forms.

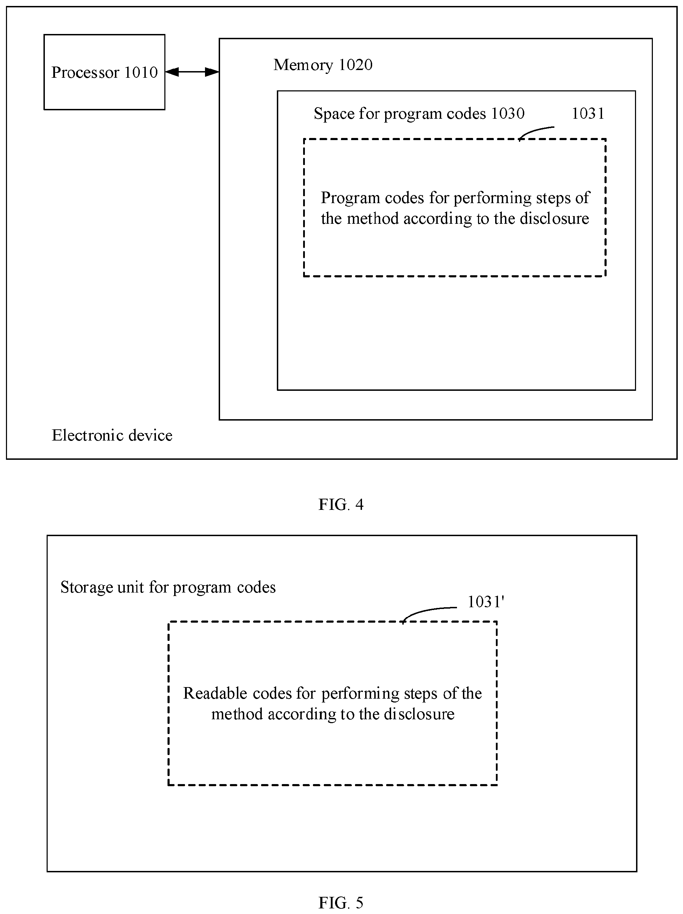

For example, FIG. 4 shows an electronic device capable of implementing the method according to the present invention. The electronic device traditionally includes a processor 1010 and a computer program product or a computer-readable medium in a form of a memory 1020. The memory 1020 can be an electronic memory such as a flash memory, an Electrically Erasable Programmable Read-Only Memory (EEPROM), an Erasable Programmable Read-Only Memory ((EPROM), a hard disk or a Read-Only Memory (ROM). The memory 1020 is provided with a storage space 1030 for program codes 1031 for performing any method step in the above-mentioned method. For example, the storage space 1030 for the program codes can include the various program codes 1031 respectively used for implementing the various steps in the above method. These program codes can be read from or written into one or more computer program products. These computer program products include program code carriers such as a hard disk, a Compact Disc (DC), a storage card or a floppy disk. Such a computer program product is usually a portable or fixed storage unit with reference to FIG. 5. The storage unit can be provided with a storage segment, a storage space, etc. having similar layout as the memory 1020 in the electronic device in FIG. 4. The program codes can be, for example, compressed in an appropriate form. Usually, the storage unit includes computer-readable codes 1031',that is, codes that can be read by a processor such as the processor 1010, and these codes, when run by the electronic device, make the electronic device perform each step in the method described as above.

The same or similar parts among all the embodiments can refer to each other, and the emphasis in each of the embodiments in the description will focus on differences from other embodiments.

Finally, it should be further noted that relational terms such as first and second described herein are only used to distinguish one entity or operation from another one, but do not necessarily require or imply the presence of any such actual relationship or order between these entities or operations. Moreover, terms "includes", "including" or any other variants thereof are intended to cover non-excludable inclusion, such that a process, method, article or terminal including a series of elements not only includes those elements, but also includes other elements not listed clearly, or further includes inherent elements of the process, method, article or terminal. In the case that there are no more limitations, elements defined by the word "including a..." do not exclude other same elements further existing in the process, method, article or terminal including the elements.

## Claims

1. A calibration method of an OCV-SOC functional relational expression of a battery, wherein the method comprises:
acquiring a charging and discharging OCV-SOC curve, a charging OCV-SOC curve and a discharging OCV-SOC curve of the battery;
fitting the charging and discharging OCV-SOC curve, the charging OCV-SOC curve and the discharging OCV-SOC curve of the battery respectively to obtain a charging and discharging OCV-SOC functional relational expression, a charging OCV-SOC functional relational expression and a discharging OCV-SOC functional relational expression;
**characterized in that** the method further comprises fitting the charging OCV-SOC functional relational expression, the discharging OCV-SOC functional relational expression and the charging and discharging OCV-SOC functional relational expression to obtain a target OCV-SOC functional relational expression with hysteresis coefficients of the battery.

2. The calibration method according to claim 1, wherein the acquiring a charging and discharging OCV-SOC curve of the battery comprises:
charging the battery at a first preset current rate intermittently until the battery is fully charged;
discharging the battery at a second preset current rate intermittently, and after standing the battery for a first preset time period every time when discharge is performed, measuring an OCV value of the battery, and recording a corresponding SOC value; and
drawing the charging and discharging OCV-SOC curve of the battery according to a plurality of pairs of OCV values and SOC values obtained by performing discharge for a plurality of times.

3. The calibration method according to claim 2, wherein the charging the battery intermittently comprises:
after standing the battery for a second preset time period every time when the battery is charged, and then charging the battery for the next time, wherein a duration of the second preset time period is a duration required to wait for an OCV of the battery to be no longer decrease after the battery is charged every time.

4. The calibration method according to claim 1, wherein
the charging and discharging OCV-SOC functional relational expression is expressed as: ${U}_{charge and discharge} = {P}_{6} ∗ {X}^{6} + {P}_{5} ∗ {X}^{5} + {P}_{4} ∗ {X}^{4} + {P}_{3} ∗ {X}^{3} + {P}_{2} ∗ {X}^{2} + {P}_{1} ∗ {X}^{1} + {P}_{0}$
wherein *U_{charge and discharge}* is an OCV value, X is an SOC value, and P is a coefficient;
the charging OCV-SOC functional relational expression is: ${U}_{charge} = P {′}_{6} ∗ {X}^{6} + P {′}_{5} ∗ {X}^{5} + P {′}_{4} ∗ {X}^{4} + P {′}_{3} ∗ {X}^{3} + P {′}_{2} ∗ {X}^{2} + P {′}_{1} ∗ {X}^{1} + P {′}_{0}$
wherein *U_{charge}* is an OCV value, X is an SOC value, and P' is a coefficient; and
the discharging OCV-SOC functional relational expression is : ${U}_{discharge} = P {"}_{6} ∗ {X}^{6} + P {"}_{5} ∗ {X}^{5} + P {"}_{4} ∗ {X}^{4} + P {"}_{3} ∗ {X}^{3} + P {"}_{2} ∗ {X}^{2} + P {"}_{1} ∗ {X}^{1} + P {"}_{0}$
wherein *U_{discharge}* is an OCV value, X is an SOC value, and P" is a coefficient.

5. The calibration method according to claim 4, wherein
the target OCV-SOC functional relational expression is: $U = \left({X}^{6}+{X}^{5}+{X}^{4}+{X}^{3}+{X}^{2}+{X}^{1}+{X}^{0}\right) ∗ \left(\frac{{P}_{6}}{\frac{1}{P {′}_{6}} + \frac{1}{P {"}_{6}}}∗\frac{{P}_{5}}{\frac{1}{P {′}_{5}} + \frac{1}{P {"}_{5}}}∗\frac{{P}_{4}}{\frac{1}{P {′}_{4}} + \frac{1}{P {"}_{4}}}∗\frac{{P}_{3}}{\frac{1}{P {′}_{3}} + \frac{1}{P {"}_{3}}}∗\frac{{P}_{2}}{\frac{1}{P {′}_{2}} + \frac{1}{P {"}_{2}}}∗\frac{{P}_{1}}{\frac{1}{P {′}_{1}} + \frac{1}{P {"}_{1}}}\right)$
wherein U is an OCV value, X is an SOC value, P is a coefficient in a charging and discharging OCV-SOC function, P' is a coefficient in a charging OCV-SOC function, and P" is a coefficient in a discharging OCV-SOC function.

6. The calibration method according to claim 2, wherein the discharging the battery at a second preset current rate intermittently comprises:
after discharge is performed every time, comparing a pair of OCV value and SOC value obtained by discharge performed this time with the discharging OCV-SOC curve of the battery;
stopping discharging the battery in the case that the pair of OCV value and SOC value obtained by discharge performed this time coincides with the discharging OCV-SOC curve of the battery; and
discharging the battery for the next time intermittently at the second preset current rate in the case that the pair of OCV value and SOC value obtained by discharge performed this time does not coincide with the discharging OCV-SOC curve of the battery.

7. The calibration method according to claim 6, wherein the drawing the charging and discharging OCV-SOC curve of the battery according to a plurality of pairs of OCV values and SOC values obtained by performing discharge for a plurality of times comprises:
drawing the charging and discharging OCV-SOC curve of the battery according to the plurality of pairs of OCV values and SOC values obtained by performing discharge for a plurality of times and the discharging OCV-SOC curve of the battery.

8. The calibration method according to claim 2, wherein the discharging the battery at a second preset current rate intermittently comprises:
discharging the battery at the second preset current rate intermittently until the SOC value of the battery is decreased to 0%.

9. An estimation method of SOC of a battery, comprising:
detecting an OCV value of a battery; and
querying, according to the OCV value, an OCV-SOC functional relational expression of the battery obtained on the basis of the calibration method according to any one of claims 1 to 8 to obtain a target SOC value.

10. A calibration apparatus of a OCV-SOC curve of a battery, comprising:
a curve measurement module configured to acquire a charging and discharging OCV-SOC curve, a charging OCV-SOC curve and a discharging OCV-SOC curve of the battery;
a calculation module configured to fit the charging and discharging OCV-SOC curve, the charging OCV-SOC curve and the discharging OCV-SOC curve of the battery respectively to obtain a charging and discharging OCV-SOC functional relational expression, a charging OCV-SOC functional relational expression and a discharging OCV-SOC functional relational expression;
**characterized in that** it further comprises
a fitting module configured to fit the charging OCV-SOC functional relational expression, the discharging OCV-SOC functional relational expression and the charging and discharging OCV-SOC functional relational expression to obtain a target OCV-SOC functional relational expression with hysteresis coefficients of the battery.

11. An estimation apparatus of an SOC of a battery, comprising:
a detection module configured to detect an OCV value of a battery; and
a querying module configured to query, according to the OCV value, an OCV-SOC functional relational expression of the battery obtained on the basis of the calibration method according to any one of claims 1 to 8 to obtain a target SOC value.

12. A computer-readable storage medium, on which computer program instructions are stored, wherein the program instructions are executed by a processor to implement the steps of the calibration method of an OCV-SOC functional relational expression of a battery according to any one of claims 1 to 8 or the estimation method of an SOC of a battery according to claim 9.

13. A vehicle, comprising the calibration apparatus of a OCV-SOC curve of a battery according to claim 10 or the estimation apparatus of an SOC of a battery according to claim 11.

14. A computer program product, comprising computer-readable codes, wherein when the computer-readable codes run on an electronic device, the electronic device performs the calibration method of an OCV-SOC functional relational expression of a battery according to any one of claims 1 to 8 or the estimation method of an SOC of a battery according to claim 9.

## Patentansprüche

1. Kalibrierungsverfahren eines OCV-SOC-Funktionsbeziehungsausdrucks einer Batterie, wobei das Verfahren aufweist:
Erfassen einer Lade-Entlade-OCV-SOC-Kurve, einer Lade-OCV-SOC-Kurve und einer Entlade-OCV-SOC-Kurve der Batterie;
Anpassen der Lade-Entlade-OCV-SOC-Kurve, der Lade-OCV-SOC-Kurve und der Entlade-OCV-SOC-Kurve der Batterie jeweils, um einen Lade-Entlade-OCV-SOC-Funktionsbeziehungsausdruck, einen Lade-OCV-SOC-Funktionsbeziehungsausdruck und einen Entlade-OCV-SOC-Funktionsbeziehungsausdruck zu erhalten;
**dadurch gekennzeichnet, dass** das Verfahren ferner aufweist
Anpassen des Lade-OCV-SOC-Funktionsbeziehungsausdrucks, des Entlade-OCV-SOC-Funktionsbeziehungsausdrucks und des Lade-Entlade-OCV-SOC-Funktionsbeziehungsausdrucks, um einen Ziel-OCV-SOC-Funktionsbeziehungsausdruck mit Hysteresekoeffizienten der Batterie zu erhalten.

2. Kalibrierungsverfahren nach Anspruch 1, wobei das Erfassen einer Lade-Entlade-OCV-SOC-Kurve der Batterie aufweist:
intermittierendes Laden der Batterie mit einer ersten voreingestellten Stromrate, bis die Batterie vollständig geladen ist;
intermittierendes Entladen der Batterie mit einer zweiten voreingestellten Stromrate und, nach Ruhenlassen der Batterie für eine erste voreingestellte Zeitspanne jedes Mal, wenn ein Entladen durchgeführt wird, Messen eines OCV-Werts der Batterie und Aufzeichnen eines entsprechenden SOC-Werts; und
Zeichnen der Lade-Entlade-OCV-SOC-Kurve der Batterie anhand einer Vielzahl von Paaren von OCV-Werten und SOC-Werten, die durch Durchführen des Entladens eine Vielzahl von Malen erhalten werden.

3. Kalibrierungsverfahren nach Anspruch 2, wobei das intermittierende Laden der Batterie aufweist:
nachdem die Batterie für eine zweite voreingestellte Zeitspanne jedes Mal, wenn die Batterie geladen wird, ruhen gelassen wurde, und dann Laden der Batterie für das nächste Mal, wobei eine Dauer der zweiten voreingestellten Zeitspanne eine Dauer ist, die erforderlich ist, um abzuwarten, dass eine OCV der Batterie sich nach jedem Laden der Batterie nicht mehr verringert.

4. Kalibrierungsverfahren nach Anspruch 1, wobei
der Lade-Entlade-OCV-SOC-Funktionsbeziehungsausdruck wird ausgedrückt als: ${U}_{charge and discharge} = {P}_{6} ∗ {X}^{6} + {P}_{5} ∗ {X}^{5} + {P}_{4} ∗ {X}^{4} + {P}_{3} ∗ {X}^{3} + {P}_{2} ∗ {X}^{2} + {P}_{1} ∗ {X}^{1} + {P}_{0}$
*wobei U_{charge and discharge}* ein OCV-Wert ist, X ein SOC-Wert ist und P ein Koeffizient ist;
der Lade-OCV-SOC-Funktionsbeziehungsausdruck ist: ${U}_{charge} = P {′}_{6} ∗ {X}^{6} + P {′}_{5} ∗ {X}^{5} + P {′}_{4} ∗ {X}^{4} + P {′}_{3} ∗ {X}^{3} + P {′}_{2} ∗ {X}^{2} + P {′}_{1} ∗ {X}^{1} + P {′}_{0}$
wobei *U_{charge}* ein OCV-Wert ist, X ein SOC-Wert ist und *P*' ein Koeffizient ist; und
der Entlade-OCV-SOC-Funktionsbeziehungsausdruck ist: ${U}_{discharge} = P {"}_{6} ∗ {X}^{6} + P {"}_{5} ∗ {X}^{5} + P {"}_{4} ∗ {X}^{4} + P {"}_{3} ∗ {X}^{3} + P {"}_{2} ∗ {X}^{2} + P {"}_{1} ∗ {X}^{1} + P {"}_{0}$
wobei *U_{discharge}* ein OCV-Wert ist, *X* ein SOC-Wert ist und *P*" ein Koeffizient ist.

5. Kalibrierungsverfahren nach Anspruch 4, wobei
der Ziel-OCV-SOC-Funktionsbeziehungsausdruck ist: $U = \left({X}^{6}+{X}^{5}+{X}^{4}+{X}^{3}+{X}^{2}+{X}^{1}+{X}^{0}\right) ∗ \left(\frac{{P}_{6}}{\frac{1}{P {′}_{6}} + \frac{1}{P {"}_{6}}}∗\frac{{P}_{5}}{\frac{1}{P {′}_{5}} + \frac{1}{P {"}_{5}}}∗\frac{{P}_{4}}{\frac{1}{P {′}_{4}} + \frac{1}{P {"}_{4}}}∗\frac{{P}_{3}}{\frac{1}{P {′}_{3}} + \frac{1}{P {"}_{3}}}∗\frac{{P}_{2}}{\frac{1}{P {′}_{2}} + \frac{1}{P {"}_{2}}}∗\frac{{P}_{1}}{\frac{1}{P {′}_{1}} + \frac{1}{P {"}_{1}}}\right)$
wobei *U* ein OCV-Wert ist, X ein SOC-Wert ist, *P* ein Koeffizient in einer Lade-Entlade-OCV-SOC-Funktion ist, *P*' ein Koeffizient in einer Lade-OCV-SOC-Funktion ist und *P*" ein Koeffizient in einer Entlade-OCV-SOC-Funktion ist.

6. Kalibrierungsverfahren nach Anspruch 2, wobei das intermittierende Entladen der Batterie mit einer zweiten voreingestellten Stromrate aufweist:
nachdem ein Entladen jedes Mal durchgeführt wurde, Vergleichen eines Paares von OCV-Wert und SOC-Wert, das durch das dieses Mal durchgeführte Entladen erhalten wird, mit der Entlade-OCV-SOC-Kurve der Batterie;
Stoppen des Entladens der Batterie in dem Fall, dass das Paar von OCV-Wert und SOC-Wert, das durch das dieses Mal durchgeführte Entladen erhalten wird, mit der Entlade-OCV-SOC-Kurve der Batterie übereinstimmt; und
intermittierendes Entladen der Batterie für das nächste Mal mit der zweiten voreingestellten Stromrate in dem Fall, dass das Paar von OCV-Wert und SOC-Wert, das durch das dieses Mal durchgeführte Entladen erhalten wird, nicht mit der Entlade-OCV-SOC-Kurve der Batterie übereinstimmt.

7. Kalibrierungsverfahren nach Anspruch 6, wobei das Zeichnen der Lade-Entlade-OCV-SOC-Kurve der Batterie anhand einer Vielzahl von Paaren von OCV-Werten und SOC-Werten, die durch Durchführen des Entladens eine Vielzahl von Malen erhalten werden, aufweist:
Zeichnen der Lade-Entlade-OCV-SOC-Kurve der Batterie anhand der Vielzahl von Paaren von OCV-Werten und SOC-Werten, die durch Durchführen des Entladens eine Vielzahl von Malen erhalten werden, und der Entlade-OCV-SOC-Kurve der Batterie.

8. Kalibrierungsverfahren nach Anspruch 2, wobei das intermittierende Entladen der Batterie mit einer zweiten voreingestellten Stromrate aufweist:
intermittierendes Entladen der Batterie mit der zweiten voreingestellten Stromrate, bis der SOC-Wert der Batterie auf 0 % verringert ist.

9. Schätzungsverfahren eines SOC einer Batterie, aufweisend:
Detektieren eines OCV-Werts einer Batterie; und
Abfragen, gemäß dem OCV-Wert, eines OCV-SOC-Funktionsbeziehungsausdrucks der Batterie, der auf der Grundlage des Kalibrierungsverfahrens nach einem der Ansprüche 1 bis 8 erhalten wird, um einen Ziel-SOC-Wert zu erhalten.

10. Kalibrierungsvorrichtung einer OCV-SOC-Kurve einer Batterie, aufweisend:
ein Kurvenmessmodul, das dazu konfiguriert ist, eine Lade-Entlade-OCV-SOC-Kurve, eine Lade-OCV-SOC-Kurve und eine Entlade-OCV-SOC-Kurve der Batterie zu erfassen;
ein Berechnungsmodul, das dazu konfiguriert ist, die Lade-Entlade-OCV-SOC-Kurve, die Lade-OCV-SOC-Kurve und die Entlade-OCV-SOC-Kurve der Batterie jeweils anzupassen, um einen Lade-Entlade-OCV-SOC-Funktionsbeziehungsausdruck, einen Lade-OCV-SOC-Funktionsbeziehungsausdruck und einen Entlade-OCV-SOC-Funktionsbeziehungsausdruck zu erhalten;
**dadurch gekennzeichnet, dass** sie ferner aufweist
ein Anpassungsmodul, das dazu konfiguriert ist, den Lade-OCV-SOC-Funktionsbeziehungsausdruck, den Entlade-OCV-SOC-Funktionsbeziehungsausdruck und den Lade-Entlade-OCV-SOC-Funktionsbeziehungsausdruck anzupassen, um einen Ziel-OCV-SOC-Funktionsbeziehungsausdruck mit Hysteresekoeffizienten der Batterie zu erhalten.

11. Schätzungsvorrichtung eines SOC einer Batterie, aufweisend:
ein Detektionsmodul, das dazu konfiguriert ist, einen OCV-Wert einer Batterie zu detektieren; und
ein Abfragemodul, das dazu konfiguriert ist, gemäß dem OCV-Wert einen OCV-SOC-Funktionsbeziehungsausdruck der Batterie, der auf der Grundlage des Kalibrierungsverfahrens nach einem der Ansprüche 1 bis 8 erhalten wird, abzufragen, um einen Ziel-SOC-Wert zu erhalten.

12. Computerlesbares Speichermedium, auf dem Computerprogrammbefehle gespeichert sind, wobei die Programmbefehle von einem Prozessor ausgeführt werden, um die Schritte des Kalibrierungsverfahrens eines OCV-SOC-Funktionsbeziehungsausdrucks einer Batterie nach einem der Ansprüche 1 bis 8 oder des Schätzungsverfahrens eines SOC einer Batterie nach Anspruch 9 zu implementieren.

13. Fahrzeug, aufweisend die Kalibrierungsvorrichtung einer OCV-SOC-Kurve einer Batterie nach Anspruch 10 oder die Schätzungsvorrichtung eines SOC einer Batterie nach Anspruch 11.

14. Computerprogrammprodukt, aufweisend computerlesbare Codes, wobei, wenn die computerlesbaren Codes auf einem elektronischen Gerät laufen, das elektronische Gerät das Kalibrierungsverfahren eines OCV-SOC-Funktionsbeziehungsausdrucks einer Batterie nach einem der Ansprüche 1 bis 8 oder das Schätzungsverfahren eines SOC einer Batterie nach Anspruch 9 durchführt.

## Revendications

1. Procédé d'étalonnage d'une expression de relation fonctionnelle OCV-SOC d'une batterie, dans lequel le procédé comprend les étapes suivantes :
acquérir respectivement une courbe OCV-SOC de charge et décharge, une courbe OCV-SOC de charge, et une courbe OCV-SOC de décharge de la batterie ;
ajuster respectivement la courbe OCV-SOC de charge et décharge, la courbe OCV-SOC de charge, et la courbe OCV-SOC de décharge de la batterie, afin d'obtenir une expression de relation fonctionnelle OCV-SOC de charge et décharge, une expression de relation fonctionnelle OCV-SOC de charge, et une expression de relation fonctionnelle OCV-SOC de décharge,
**caractérisé en ce que** le procédé comprend en outre l'étape suivante :
ajuster l'expression de relation fonctionnelle OCV-SOC de charge, l'expression de relation fonctionnelle OCV-SOC de décharge, et l'expression de relation fonctionnelle OCV-SOC de charge et décharge afin d'obtenir une expression de relation fonctionnelle OCV-SOC cible avec des coefficients d'hystérésis de la batterie.

2. Procédé d'étalonnage selon la revendication 1, dans lequel l'acquisition d'une courbe OCV-SOC de charge et décharge de la batterie comprend les étapes suivantes :
charger la batterie à un premier débit de courant préréglé de manière intermittente jusqu'à ce que la batterie soit entièrement chargée ;
décharger la batterie à un second débit de courant préréglé de manière intermittente, et après que la batterie est restée sur une première période de temps préréglée à chaque fois que la décharge est réalisée, mesurer une valeur OCV de la batterie, et enregistrer une valeur SOC correspondante, et
tracer la courbe OCV-SOC de charge et décharge de la batterie conformément à une pluralité de paires de valeurs OCV et de valeurs SOC obtenues en réalisant la décharge pendant une pluralité de fois.

3. Procédé d'étalonnage selon la revendication 2, dans lequel l'étape pour charger la batterie de manière intermittente comprend l'étape suivante :
après que la batterie reste pendant une seconde période de temps préréglée à chaque fois que la batterie est chargée, charger ensuite la batterie pour la prochaine fois, dans lequel une durée de la seconde période de temps préréglée est une durée requise en attendant qu'une OCV de la batterie ne soit plus en diminution après que la batterie est à chaque fois chargée.

4. Procédé d'étalonnage selon la revendication 1, dans lequel
l'expression de relation fonctionnelle OCV-SOC de charge et décharge est exprimée sous la forme : ${U}_{charge and discharge} = {P}_{6} ∗ {X}^{6} + {P}_{5} ∗ {X}^{5} + {P}_{4} ∗ {X}^{4} + {P}_{3} ∗ {X}^{3} + {P}_{2} ∗ {X}^{2} + {P}_{1} ∗ {X}^{1} + {P}_{0}$
dans lequel U_{charge and discharge} est une valeur OCV ; X est une valeur SOC, et P est un coefficient ;
l'expression de relation fonctionnelle OCV-SOC de charge est : ${U}_{charge} = P {′}_{6} ∗ {X}^{6} + P {′}_{5} ∗ {X}^{5} + P {′}_{4} ∗ {X}^{4} + P {′}_{3} ∗ {X}^{3} + P {′}_{2} ∗ {X}^{2} + P {′}_{1} ∗ {X}^{1} + P {′}_{0}$
dans lequel U_{charge} est une valeur OCV ; X est une valeur SOC, et P' est un coefficient, et
l'expression de relation fonctionnelle OCV-SOC de décharge est : ${U}_{discharge} = P {"}_{6} ∗ {X}^{6} + P {"}_{5} ∗ {X}^{5} + P {"}_{4} ∗ {X}^{4} + P {"}_{3} ∗ {X}^{3} + P {"}_{2} ∗ {X}^{2} + P {"}_{1} ∗ {X}^{1} + P {"}_{0}$
dans lequel U_{discharge} est une valeur OCV ; X est une valeur SOC, et P'' est un coefficient.

5. Procédé d'étalonnage selon la revendication 4, dans lequel
l'expression de relation fonctionnelle OCV-SOC cible est : $U = \left({X}^{6}+{X}^{5}+{X}^{4}+{X}^{3}+{X}^{2}+{X}^{1}+{X}^{0}\right) ∗ \left(\frac{{P}_{6}}{\frac{1}{P {′}_{6}} + \frac{1}{P {"}_{6}}}∗\frac{{P}_{5}}{\frac{1}{P {′}_{5}} + \frac{1}{P {"}_{5}}}∗\frac{{P}_{4}}{\frac{1}{P {′}_{4}} + \frac{1}{P {"}_{4}}}∗\frac{{P}_{3}}{\frac{1}{P {′}_{3}} + \frac{1}{P {"}_{3}}}∗\frac{{P}_{2}}{\frac{1}{P {′}_{2}} + \frac{1}{P {"}_{2}}}∗\frac{{P}_{1}}{\frac{1}{P {′}_{1}} + \frac{1}{P {"}_{1}}}\right)$
dans lequel U est une valeur OCV ; X est une valeur SOC ; P est un coefficient dans une fonction OCV-SOC de charge et de décharge ; P' est un coefficient dans une fonction OCV-SOC de charge, et P" est un coefficient dans une fonction OCV-SOC de décharge.

6. Procédé d'étalonnage selon la revendication 2, dans lequel la décharge de la batterie à un second débit de courant préréglé de manière intermittente comprend l'étape suivante :
après que la décharge est réalisée à chaque fois, comparer une paire consistant en une valeur OCV et une valeur SOC obtenue par la décharge réalisée cette fois avec la courbe OCV-SOC de décharge de la batterie ;
arrêter la décharge de la batterie dans le cas où la paire consistant en une valeur OCV et une valeur SOC obtenue par la décharge réalisée cette fois coïncide avec la courbe OCV-SOC de décharge de la batterie, et
décharger la batterie pour la prochaine fois de manière intermittente sur le second débit de courant préréglé dans le cas où la paire consistant en une valeur OCV et une valeur SOC obtenue par la décharge réalisée cette fois ne coïncide pas avec la courbe OCV-SOC de décharge de la batterie.

7. Procédé d'étalonnage selon la revendication 6, dans lequel le traçage de la courbe OCV-SOC de charge et décharge de la batterie conformément à une pluralité de paires de valeurs OCV et de valeurs SOC obtenues en réalisant la décharge pendant une pluralité de fois comprend l'étape suivante :
tracer la courbe OCV-SOC de charge et décharge de la batterie conformément à la pluralité de paires de valeurs OCV et de valeurs SOC obtenues en réalisant la décharge pendant une pluralité de fois et la courbe OCV-SOC de décharge de la batterie.

8. Procédé d'étalonnage selon la revendication 2, dans lequel la décharge de la batterie à un second débit de courant préréglé de manière intermittente comprend l'étape suivante :
décharger la batterie au second débit de courant préréglé de manière intermittente jusqu'à ce que la valeur SOC de la batterie soit descendue à 0 %.

9. Procédé d'estimation de SOC d'une batterie, comprenant les étapes suivantes :
détecter une valeur OCV d'une batterie, et
interroger, conformément à la valeur OCV, une expression de relation fonctionnelle OCV-SOC de la batterie obtenue sur la base du procédé d'étalonnage selon l'une quelconque des revendications 1 à 8, afin d'obtenir une valeur SOC cible.

10. Appareil d'étalonnage d'une courbe OCV-SOC d'une batterie, comprenant :
un module de mesure de courbe configuré pour acquérir une courbe OCV-SOC de charge et décharge, une courbe OCV-SOC de charge, et une courbe OCV-SOC de décharge de la batterie ;
un module de calcul de courbe configuré pour ajuster respectivement la courbe OCV-SOC de charge et décharge, la courbe OCV-SOC de charge, et la courbe OCV-SOC de décharge de la batterie, afin d'obtenir une expression de relation fonctionnelle OCV-SOC de charge et décharge, une expression de relation fonctionnelle OCV-SOC de charge, et une expression de relation fonctionnelle OCV-SOC de décharge,
**caractérisé en ce qu'**il comprend en outre:
un module d'ajustement pour ajuster l'expression de relation fonctionnelle OCV-SOC de charge, l'expression de relation fonctionnelle OCV-SOC de décharge, et l'expression de relation fonctionnelle OCV-SOC de charge et de décharge, afin d'obtenir une expression de relation fonctionnelle OCV-SOC cible avec des coefficients d'hystérésis de la batterie.

11. Appareil d'estimation de SOC d'une batterie, comprenant :
un module de détection configuré pour détecter une valeur OCV d'une batterie, et
un module d'interrogation configuré pour interroger, conformément à la valeur OCV, une expression de relation fonctionnelle OCV-SOC de la batterie obtenue sur la base du procédé d'étalonnage selon l'une quelconque des revendications 1 à 8, afin d'obtenir une valeur SOC cible.

12. Support de stockage lisible par ordinateur stockant un programme informatique, sur lequel des instructions de programme informatique sont stockées, dans lequel les instructions de programme sont exécutées par un processeur afin de mettre en œuvre les étapes du procédé d'étalonnage d'une expression de relation fonctionnelle OCV-SOC d'une batterie selon l'une quelconque des revendications 1 à 8 ou du procédé d'estimation d'une SOC d'une batterie selon la revendication 9.

13. Véhicule, comprenant l'appareil d'étalonnage d'une courbe OCV-SOC d'une batterie selon la revendication 10 ou l'appareil d'estimation d'une SOC d'une batterie selon la revendication 11.

14. Produit de programme informatique, comprenant des codes lisibles par ordinateur, dans lequel les codes lisibles par ordinateur fonctionnent sur un dispositif électronique, et le dispositif électronique réalise le procédé d'étalonnage d'une expression de relation fonctionnelle OCV-SOC d'une batterie selon l'une quelconque des revendications 1 à 8 ou le procédé d'estimation de SOC d'une batterie selon la revendication 9.
